Europäisches Patentamt

European Patent Office

Office européen des brevets

(11) Veröffentlichungsnummer: **0 226 820 B1**

(12) **EUROPÄISCHE PATENTSCHRIFT**

(45) Veröffentlichungstag der Patentschrift: **20.02.91**

(51) Int. Cl.⁵: **H05K 7/14**, H01R 23/72

(21) Anmeldenummer: **86116009.1**

(22) Anmeldetag: **18.11.86**

(54) **Vorrichtung zum Befestigen von Zentrierleisten.**

(30) Priorität: **29.11.85 DE 3542288**

(43) Veröffentlichungstag der Anmeldung:
**01.07.87 Patentblatt  87/27**

(45) Bekanntmachung des Hinweises auf die
Patenterteilung:
**20.02.91 Patentblatt  91/08**

(84) Benannte Vertragsstaaten:
**AT BE CH DE FR GB IT LI NL SE**

(56) Entgegenhaltungen:
**DE-A- 2 441 670**
**US-A- 3 597 722**
**US-A- 3 950 060**
**US-A- 4 046 445**
**US-A- 4 480 885**

**Siemens Components, 21.Jahrgang**
**(1983),Heft 6,Seiten 245-249**

(73) Patentinhaber: **Siemens Aktiengesellschaft**
**Wittelsbacherplatz 2**
**D-8000 München 2(DE)**

(72) Erfinder: **Seidel, Peter**
**Mittenwalderstrasse 256**
**D-8038 Gröbenzell(DE)**
Erfinder: **Pelzl, Leo**
**Alpenblickstrasse 5**
**D-8150 Holzkirchen(DE)**
Erfinder: **Zell, Karl**
**Moritz-von-Schwind-Weg 80**
**D-8134 Niederpöcking(DE)**

EP 0 226 820 B1

## Beschreibung

Die Erfindung betrifft eine Vorrichtung zum Befestigen von zur Aufnahme von Kabelsteckern bzw. Baugruppen dienenden Zentrierleisten an Kontaktmessern, wobei die Zentrierleisten auf die Kontaktmesser der Rückwandleiterplatte eines Baugruppenrahmens aufsteckbar sind und die freien Enden der Kontaktmesser durch Durchbrüche im Zentrierleistenboden in die Zentrierleiste hineinragen.

Es ist bekannt, derartige Zentrierleisten an ihren Enden mit Flanschen zu versehen und sie mittels dieser Flansche am Baugruppenrahmen zu besteigen (s.z.B. Siemens Components 21 (1983) Heft 6, Seite 245, Bild 11). Dienen die Zentrierleisten z.B. zur Aufnahme von einem oder mehreren Kabelsteckern, so treten beim Stecken bzw. Ziehen der Kabelstecker erhebliche Druck-bzw. Zugkräfte auf, die zu einer Zerstörung der Zentrierleiste oder einzelner Messer führen können. Das Problem der Zerstörung tritt insbesondere dann auf, wenn Kabelstecker im mittleren Teil der Zentrierleiste gesteckt bzw. gezogen werden müssen.

Aufgabe der vorliegenden Erfindung ist es, eine Vorrichtung zum Befestigen von Zentrierleisten an einer Rückwandleiterplatteanzugeben, welche verhindert, daß es beim Stecken bzw. Ziehen von Kabelsteckern zu Beschädigungen von Zentrierleiste oder Messern kommt.

Diese Aufgabe wird für eine Vorrichtung der eingangs genannten Art erfindungsgemäß dadurch gelöst, daß im Zentrierleistenboden mehrere im Bereich der Durchbrüche eingebettete Befestigungsscheiben, die mit weiteren Durchbrüchen zum Durchstecken der Kontaktmesser versehen sind, so ausgebildet sind, daß sie durch Verdrehung mit Teilen der inneren Kanten der Befestigungsscheiben in das Kontaktmesser und mit Teilen der äußeren Kanten der Befestigungsscheiben in das Bodenmaterial der Zentrierleiste einschneiden.

Die erfindungsgemäße Vorrichtung ermöglicht eine feste Verbindung der Zentrierleiste mit den Kontaktmessern über die gesamte Länge der Zentrierleiste. Bei der Drehung der Befestigungsscheiben schneiden sich die Kanten der Durchbrüche in die Kontaktmesser ein. Gleichzeitig erfolgt auch eine Überschneidung der Aussenkontur der Befestigungsscheiben mit den Zentrierleistenkörper. Es erfolgt somit eine formschlüssige Verankerung zwischen den Kontaktmessern, den Befestigungsscheiben und der Zentrierleiste. Die beim Stecken bzw. Ziehen von Kabelsteckern auftretenden Druck-bzw. Zugkräfte werden dadurch auf eine Vielzahl von Befestigungspunkten aufgeteilt. Dadurch wird ein Nachgeben und Verformen von Zentrierleiste und Messern beim Ziehen und Stecken von Baugruppen verhindert, wodurch Beschädigungen von Zentrierleiste und Messern verhindert werden.

Eine vorteilhafte Ausgestaltung der erfindungsgemäßen Vorrichtung ist dadurch gekennzeichnet, daß im Bereich der Durchbrüche auf der Innenseite des Zentrierleistenbodens im wesentlichen rechteckförmige Vertiefungen zur Aufnahme der Befestigungsscheiben vorgesehen sind, und daß die Befestigungsscheiben mittels an jeweils den Längskanten der Vertiefungen nach dem Einlegen der Befestigungsscheiben erfolgten Prägungen beweglich und unverlierbar gehalten sind.

Bei einer derart aufgebauten Zentrierleiste kann die Bestückung der Zentrierleiste mit den Befestigungsscheiben in einfacher Weise von oben her erfolgen. Auf ebenso einfache Weise lassen sich bei dieser Zentrierleiste die Prägungen herstellen, welche die Befestigungsscheiben beweglich und unverlierbar im Zentrierleistenboden festhalten. Da die Befestigungsscheiben auf der Innenseite des Zentrierleistenbodens angeordnet sind, sind sie nach Aufstecken der Zentrierleiste mit den Befestigungsscheiben auf die Kontaktmesser für die Befestigungsscheiben verdrehende Werkzeuge gut erreichbar.

Eine vorteilhafte Befestigungsscheibe für die erfindungsgemäße Vorrichtung ist dadurch gekennzeichnet, daß ihre Aussenkontur im wesentlichen rechteckförmig ist, wobei die längeren Aussenkanten gerade ausgebildet sind und in der Mitte liegende Vorspünge aufweisen, während die kürzeren Außenkanten kreisbogenförmig ausgebildet sind, daß in der Mitte der Befestigungsscheibe ein düsenförmiger Durchbruch vorgesehen ist, dessen Querschnitt dem Querschnitt des Kontaktmessers entspricht, bzw. minimal größer als dieser ist, und daß an zwei diagonal gegenüberliegenden Ecken Ausnehmungen zum Eingriff eines Drehwerkzeugs angeordnet sind.

Durch die düsenförmige Ausgestaltung des Durchbruches wird der Aufsteckvorgang der Zentrierleiste mit den Befestigungsscheiben auf die Kontaktmesser erleichtert, gleichzeitig werden dadurch scharfe Innenkanten geschaffen, die das Einschneiden der Innenkanten in das Kontaktmesser erleichtern. Durch die kreisbogenförmige Ausbildung der kürzeren Außenkanten wird das Einschneiden der Außenkanten in den Zentrierleistenboden beim Verdrehen der Befestigungsscheibe erleichtert.

Im folgenden wird die Erfindung anhand eines in der Zeichnung dargestellten Ausführungsbeispiels näher erläutert.

Es zeigen:

FIG 1    die prinzipielle Anorndung einer Zentrierleiste in Verbindung mit einer Rückwandleiterplatte,

FIG 2      eine teilweise Draufsicht auf einen Zentrierleistenboden einer Zentrierleiste nach der erfindungsgemäßen Vorrichtung,

FIG 3      einen teilweisen Längsschnitt durch diese Zentrierleiste,

FIG 4      einen Querschnitt durch diese Zentrierleiste, und

FIG 5, 6, 7    drei verschiedene Ansichten einer Befestigungsscheibe gemäß der vorliegenden Erfindung.

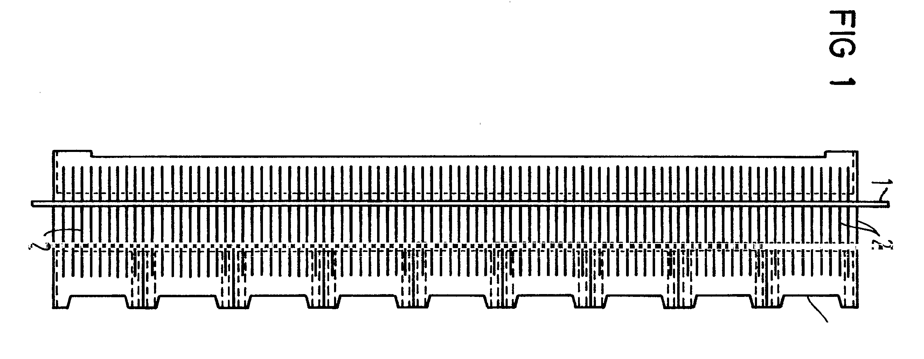

Der prinzipielle Aufbau eines Baugruppenrahmens mit Rückwandleiterplatten zur Aufnahme von Baugruppen bzw. Kabelsteckern wird als bekannt vorausgesetzt und soll daher in diesem Zusammenhang nicht näher beschrieben werden. FIG 1 zeigt lediglich die prinzipielle Anordnung einer Zentrierleiste 3 gemäß einem Ausführungsbeispiel der vorliegenden Erfindung in Verbindung mit einer Rückwandleiterplatte 1. Die Rückwandleiterplatte 1 ist mit einer Vielzahl von Kontaktmessern 2 bestückt, auf die die Zentrierleiste 3 aufsteckbar ist. Mit Hilfe der erfindungsgemäßen Vorrichtung kann die Zentrierleiste 3 in jedem beliebigen Abstand von der Rückwandleiterplatte 1 mit den Kontaktmessern 2 verbunden werden.

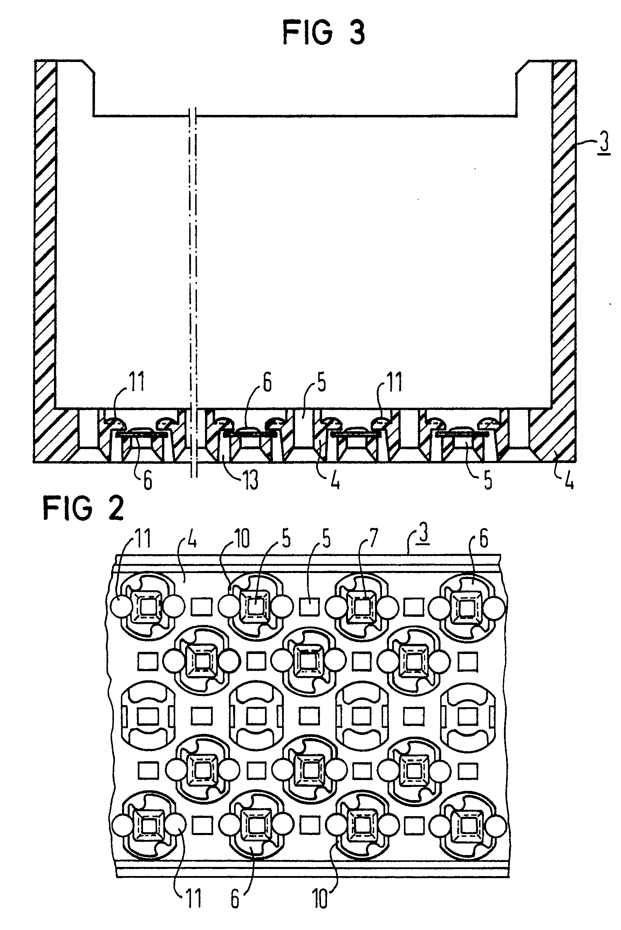

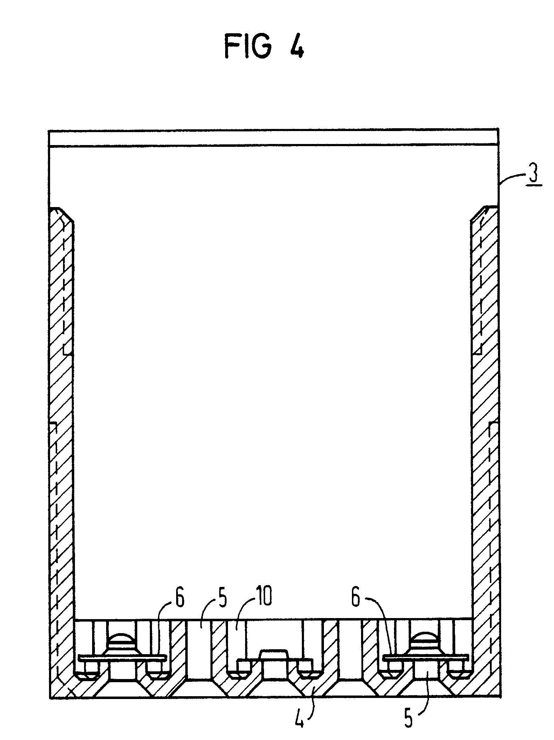

Anhand der FIG 2 bis 4 soll im folgenden die Zentrierleiste näher beschrieben werden. Bei der Zentrierleiste 3 handelt es sich um ein rechteckförmiges, einseitig offenes Gehäuse mit dem Zentrierleistenboden 4. Der Zentrierleistenboden 4 weist Durchbrüche 5 auf, durch welche die freien Enden der Kontaktmesser 2 in die Zentrierleiste hineinragen. Der Abstand der Durchbrüche 5 im Zentrierleistenboden 4 entspricht dem Abstand der Kontaktmesser 2.

Bei der dargestellten Zentrierleiste 3 ist im Bereich jeden zweiten Durchbruchs 5 eine Vertiefung 10 zur Aufnahme von Befestigungsscheiben 6 vorgesehen. Die Abmessungen der Vertiefungen 10 sind so gewählt, daß die Befestigungsscheiben 6 nach dem Einlegen ein Spiel aufweisen, so daß sie mit einer gewissen Toleranz hin- und herbewegbar sind. Dieses horizontale Spiel ist notwendig, um ein leichtes Aufstecken der mit Befestigungs-scheiben bestückten Zentrierleiste auf die Kontaktmesser zu ermöglichen.

Nach dem Einlegen der Befestigungsscheiben 6 in die Vertiefungen 10 des Zentrierliestenbodens 4 werden die Befestigungs scheiben 6 mittels Prägungen 11 unverlierbar und beweglich in den Vertiefungen 10 gehalten. Die Prägungen 11 können z.B. mittels Ultraschall erfolgen. Um auch neben der horizontalen eine vertikale Beweglichkeit der Befestigungsscheiben 6 zu erreichen, wird die Befestigungsscheibe 6 während des Prägevorgangs mit einem Werkzeug, das durch die Schlitze 13 auf die Befestigungsscheiben 6 einwirkt, in einer definierten Höhe gehalten. Bei der Zentrierleiste sind also die Befestigungsscheiben 6 unverlierbar und beweglich im Zentrierleistenboden 4 eingebettet.

Auch wenn bei der gemäß der vorliegenden Erfindung ausgestalteten Zentrierleiste 3 als Vorleistung im Bereich jedes zweiten Durchbruchs 5 eine Vertiefung 10 vorgesehen ist, so brauchen je nach Anwendungsfall nicht alle Vertiefungen 10 mit Befestigungsscheiben 6 bestückt werden. Je nach Anwendungsfall kann es zum Beispiel ausreichen, lediglich die zwei äußeren Reihen mit Befestigungsscheiben 6 zu bestücken.

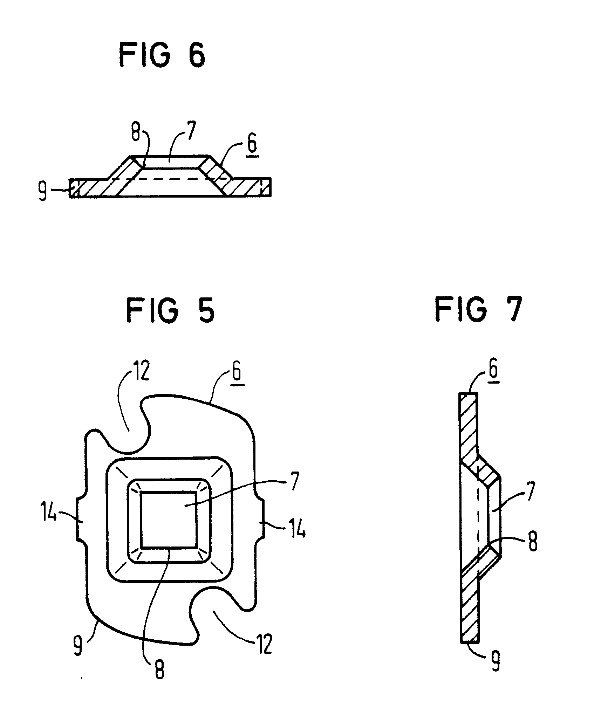

In den FIG 5 bis 7 ist eine Befestigungsscheibe gemäß einem Ausführungsbeispiel der Erfindung dargestellt. FIG 5 zeigt eine Draufsicht, FIG 6 einen Querschnitt und FIG 7 einen Längsschnitt der Befestigungsscheibe 6. Die Außenkontur der Befestigungsscheibe 6 ist im wesentlichen rechtechförmig. Die längeren Außenkanten sind gerade ausgebildet, und weisen jeweils in der Mitte Vorsprünge 14 auf. Die Vorsprünge 14 befinden sich im eingebauten Zustand der Befestigungsscheibe unter den Prägungen 11. Die kürzeren Außenkanten der Befestigungsscheibe 6 sind kreisbogenförmig ausgebildet. Der Durchbruch 7 der Befestigungsscheibe 6 ist düsenförmig ausgebildet, was den Aufsteckvorgang auf die Kontaktmesser 2 erleichtert. Die Abmessungen des Durchbruchs 7 entsprechen im wesentlichen dem Querschnitt der Kontaktmesser 2. Ein weiterer Vorteil des düsenförmig ausgebildeten Durchbruchs 7 ist der, daß eine scharfe Innenkante entsteht. An zwei diagonal gegenüberliegenden Ecken der Befestigungsscheibe 6 sind Ausnehmungen 12 vorgesehen, in welche Zapfen eines Drehwerkzeuges zum Verdrehen der Befestigungsscheibe 6 eingreifen können.

Nach dem Ausstecken der mit den Befestigungsscheiben 6 bestückten Zentrierleiste 3 auf die Kontaktmesser 2 werden, wenn sich die Zentrierleiste in der gewünschten Position befindet, mittels eines Drehwerkzeuges die Befestigungsscheiben 6 verdreht. Wird ein Drehsinn im Uhrzeigersinn vorausgesetzt, so läßt sich der FIG 5 entnehmen, daß sich alle vier scharfen Innenkanten 8 in das Material des Kontaktmessers 2 einschneiden, während die rechte obere und die linke untere Ecke der Befestigungsseibe 6 in das Bodenmaterial der Zentrierleiste 3 einschneiden. Dieses Einschneiden in das Bodenmaterial der Zentrierleiste 3 wird durch die kreisförmige Ausbildung der kürzeren Außenkanten begünstigt. Nach dem Verdrehen der Befestigungsscheiben kommt es somit zu einer formschlüssigen Verankerung zwischen den Kontaktmessern, den Befestigungsscheiben und der Zentrierleiste. Die Zug- und Druckkräfte werden somit auf eine Vielzahl von Kontaktmessern verteilt. Ein Durchbiegen der Zentrierleiste 3 zur Rückwandleiterplatte 1 hin, bzw. von dieser weg, wird dadurch verhindert. Auch wird die Stabilität der Kontaktmesser 2 vergrößert, da durch ihre Verankerung im Zentrierleistenboden 4 die freien Enden in mechanischer Sicht verkürzt werden.

## Ansprüche

1. Vorrichtung zum Befestigen von zur Aufnahme von Kabelsteckern bzw. Baugruppen dienenden Zentrierleisten, die auf die Kontaktmesser der Rückwandleiterplatte eines Baugruppenrahmens aufsteckbar sind, wobei die freien Enden der Kontaktmesser durch Durchbrüche im Zentrierleistenboden in die Zentrierleiste hineinragen,
   **dadurch gekennzeichnet,**
   daß im Zentrierleistenboden (4) mehrere im Bereich der Durchbrüche (5) eingebettete Befestigungsscheiben (6), die mit Durchbrüchen (7) zum Durchstecken der Kontaktmesser (2) versehen sind, derart verdreht werden, daß Teile der inneren Kanten (8) der Befestigungsscheiben (6) in das Kontaktmesser (2) und Teile der äußeren Kanten (9) der Befestigungsscheiben (6) in das Bodenmaterial der Zentrierleiste (3) einschneiden.

2. Vorrichtung nach Anspruch 1,
   **dadurch gekennzeichnet,**
   daß im Bereich der Durchbrüche (5) auf der Innenseite des Zentrierleistenbodens (4) im wesentlichen rechteckförmige Vertiefungen (10) zur Aufnahme der Befestigungsscheiben (6) vorgesehen sind, und daß die Befestigungsscheiben (6) mittels an jeweils den Längskanten der Vertiefungen (10) nach dem Einlegen der Befestigungsscheiben (6) erfolgten Prägung (11) beweglich und unverlierbar gehalten sind.

3. Vorrichtung nach einem der vorhergehenden Ansprüche,
   **dadurch gekennzeichnet,**
   daß die Befestigungsscheibe eine Außenkontur aufweist, die im wesentlichen rechteckförmig ist, wobei die längeren Außenkanten gerade ausgebildet sind und in der Mitte liegende Vorsprünge (14) aufweisen, während die kürzeren Außenkanten kreisbogenförmig ausgebildet sind, daß in der Mitte der Befestigungsscheibe (6) ein düsenförmiger Durchbruch (7) vorgesehen ist, dessen Querschnitt dem Querschnitt des Kontaktmessers (2) entspricht, bzw. minimal größer als dieser ist, und daß an zwei diagonal gegenüberliegenden Ecken Ausnehmungen (12) zum Eingriff eines Drehwerkzeugs angeordet sind.

## Claims

1. Device for fastening locating strips, serving to receive cable plugs or modules, to contact blades, it being possible to plug the locating strips onto the contact blades of the rear wall printed circuit board of a module frame and the free ends of the contact blades project through openings in the locating strip floor into the locating strip, characterized in that in the locating strip floor (4), a plurality of fastening discs (6) which are embedded in the region of the openings (5) and are provided with further openings (7) through which the contact blades (2) are plugged, are constructed in such a way that, by means of rotation with parts of the inner edges (8) of the fastening discs (6), they cut into the contact blade (2), and with parts of the outer edges (9) of the fastening discs (6), they cut into the floor material of the locating strip (3).

2. Device according to Claim 1, characterized in that essentially rectangular depressions (10) for receiving the fastening discs (6) are provided in the region of the openings (5) on the inside of the locating strip floor (4), and in that the fastening discs (6) are held in a movable and captive manner by means of stamping (11) occurring in each case on the longitudinal edges of the depressions (10) after the insertion of the fastening discs (6).

3. Device according to one of the previous claims, characterized in that the fastening disc has an outer contour which is essentially rectangular, the longer outer edges being straight in construction and having projections (14) situated in the centre, whilst the shorter outer edges are circular arc-shaped in construction, in that a nozzle-shaped opening (7) is provided in the centre of the fastening disc (6), the cross-section of said opening corresponding to the cross-section of the contact blade (2), and being at a minimum larger than the latter, and in that recesses (12) for the purpose of engaging a turning tool are arranged on two diagonally opposite corners.

## Revendications

1. Dispositif pour fixer des réglettes de centrage utilisées pour recevoir des conducteurs à câbles ou des modules, sur des couteaux de contact, et dans lequel les réglettes de centrage peuvent être enfichées sur les couteaux de contact de la plaquette à circuits imprimés formant paroi arrière d'un cadre porte-modules, et les extrémités libres des couteaux de contact pénètrent dans des passages ménagés dans la base de la réglette de centrage, caractérisé par le fait que dans la base (4) de la réglette de centrage, plusieurs disques de fixation (6), qui sont insérés dans la zone des passages (5) et comportent d'autres passages (7) prévus pour l'enfichage de couteaux de contact (2), sont agencés de telle sorte que sous l'effet d'une rotation, les disques de fixation (6) entaillent le couteau de contact (2) par des parties de leurs bords intérieurs (8), et le matériau de la base de la réglette de centrage (3) par des parties de leurs arêtes extérieures (9).

2. Dispositif selon la revendication 1, caractérisé par le fait qu'au niveau des passages (5) il est prévu, sur la face intérieure de la base (4) des réglettes de centrage, des renfoncements sensiblement rectangulaires (10) servant à loger des disques de fixation (6), et que ces derniers sont maintenus de manière à être mobiles et imperdables à l'aide d'une partie estampée (11) formée respectivement sur les bords longitudinaux des renfoncements (10) après l'insertion des disques de fixation (6).

3. Dispositif suivant l'une des revendications précédentes, caractérisé par le fait que le disque de fixation possède un contour extérieur de forme essentiellement rectangulaire, les bords extérieurs les plus longs étant rectilignes et possédant des parties saillantes (14) situées en leurs centres, tandis que les bords extérieurs les plus courts sont réalisés avec une forme en arc de cercle, qu'au centre du disque de fixation (6) est prévu un passage en forme de buse (7), dont la section transversale correspond à la section transversale du couteau de contact (2) ou est supérieure, seulement de façon minime, à cette section, et que des évidements (12) permettant l'engagement d'un outil rotatif sont ménagés au niveau de deux angles opposés en diagonale.

FIG 1

# FIG 3

# FIG 2

# FIG 4

# FIG 6

# FIG 5

# FIG 7